# EUROPEAN PATENT APPLICATION

(11) **EP 1 035 701 A1**
(43) Date of publication of application: **13.09.2000**
(21) Application number: 99400540.3
(22) Date of filing: 08.03.1999
(51) Int. Cl.: H04L 27/36, H04L 27/20

(54) **Modulator using envelope elimination and restoration by means of look-up tables**

(71) Applicant: MOTOROLA, INC., Schaumburg, IL 60196 (US)
(72) Inventor: Songeon, Lionel, 31170 Tournefeuille (FR)
(74) Representative: Joly, Jean-Jacques

(57) **Abstract**

The envelope elimination and restoration (eer) modulator comprises look-up table means 50, envelope post-processing means 61, phase post-processing means 62, envelope Digital to Analogue Converter (DAC) 71, phase DAC 72 and power amplifier 80. Bit generation means 10 represents the circuitry associated with the modulator which generates the data to be communicated or transmitted by the modulator (e.g. vocoder, channel codec, burst formatter, etc.) and aerial 90 is the means from which the output modulated carrier signal is broadcast. Look-up table means 50 enables a direct conversion from the bit stream to polar type signals including an envelope signal and a phase signal.

## Description

### Field of The Invention

The present invention relates to a method and apparatus for performing modulation, and in particular to a method and apparatus for performing modulation of a radio frequency (rf) carrier signal to carry a digital signal, the modulated signal having a non-constant envelope amplitude, and employing a technique referred to as envelope elimination and restoration (eer).

### Background of The Invention

In order to improve the efficiency of radio transmitters which must transmit signals having non-constant envelopes, the modulation technique eer has been developed which enables a power amplifier having a signal input and a power input to have the signal which is input to the signal input of the power amplifier to constantly saturate the power amplifier (i.e. the amplitude of the signal applied to the signal input is the maximum, or close to the maximum, which the power amplifier can amplify without substantial clipping of the signal), while variations in the envelope amplitude are achieved by varying the power supplied to the power input of the power amplifier. In order to separate the phase/frequency information from the envelope amplitude information of a modulating signal, a technique known as rectangular to polar conversion is frequently employed. However, this technique requires a large amount of processing power. Furthermore, it is not straightforward to ensure that the signal applied to the power input of the power amplifier is well synchronised to the signal applied to the signal input of the power amplifier. Furthermore, it is known that it can be advantageous to perform a certain amount of post-processing on the polar co-ordinates generated during the rectangular to polar conversion. This post-processing can also require a large amount of processing power.

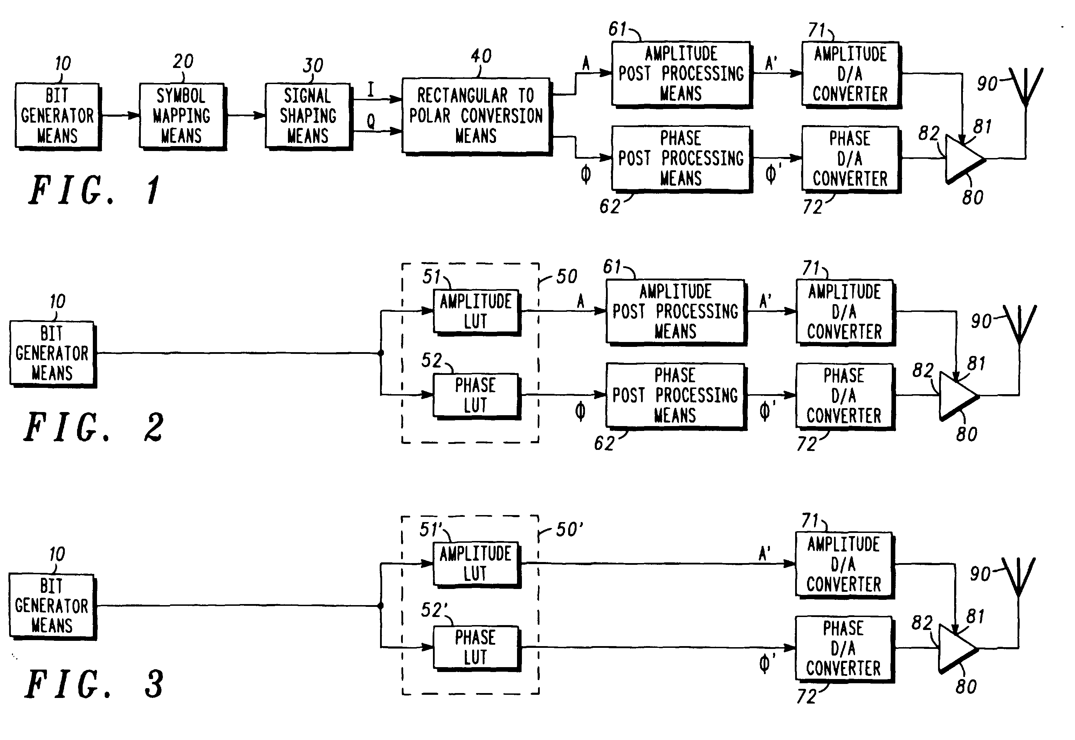

Figure 1 is a block diagram of a conventional architecture of apparatus for performing eer modulation. The apparatus comprises bit generation means 10, symbol mapping means 20, signal shaping means 30, rectangular to polar conversion means 40, amplitude or envelope post-processing means 61, phase post-processing means 62, amplitude or envelope Digital to Analogue Converter (DAC) 71, phase DAC 72, power amplifier 80 and an aerial 90.

Bit generation means 10 essentially represents the entirety of the device of which the modulation apparatus forms a part prior to the modulation apparatus; thus in the case of a mobile telephone, it would represent circuitry such as a vocoder or data generation, channel coding means, burst formatting means, etc. which finally generate a stream of bits which are to be communicated over the air interface via the modulation apparatus. The bit stream thus generated is input to the symbol mapping means 20 which groups the input bits into groups equal to the symbol size and maps this groups of input bits onto the symbol space (eg, can perform gray encoding, offsetting, transition restriction....). The output of the means 20 is then a stream of symbols which the modulation apparatus can cope with (e.g. 1, 2 ,3 or n), and then outputs at a much higher data rate, a pair of digital signals which correspond to sampled analogue In-phase (I) and Quadrature phase (Q) signals which are to modulate the carrier signal in order to communicate the corresponding symbol. These "digitally sampled" signals are then input to the signal shaping means which shapes the input signals, largely to remove any unwanted high frequency components which would not fit within the bandwidth of the channel to be used over the air interface.

The shaped I and Q signals are then input to the rectangular to polar conversion means which generates from the I and Q signals, Amplitude (A) and phase (φ) signals (as noted above, this conversion requires a large amount of processing power). The A and φ signals are then input to the amplitude and phase post-processing means 61,62 respectively where post-processing is carried out, to generate a post-processed amplitude (A') signal and a post-processed phase (φ') signal; this may, for example, remove low amplitude, high frequency components from the A signal and add them to the φ signal. The A' and φ' signals are then input to the amplitude and phase DACs 71,72 which convert the input signals from a "digitally sampled" format into analogue format which can be directly amplified by the power amplifier 80 (note that the phase DAC performs translation from baseband to the appropriate carrier frequency by means of for example: frequency upconversion, direct modulation, direct digital synthesiser or fractional-N Phase Lock Loop. The analogue amplitude signal is applied to a power input 81 of the power amplifier 80 and the analogue phase signal (which is in fact by this stage an rf analog signal, or more particularly, an analogue phase modulated carrier signal having a substantially constant amplitude sufficient to saturate the power amplifier, or drive the power amplifier close to the saturation, without being substantially clipped), is applied to a signal input 82 of the power amplifier 80. The power amplifier 80 finally outputs a non-constant envelope rf signal for broadcast via aerial 90.

### Summary of The Invention

According to the present invention, there is provided apparatus for performing modulation, the apparatus comprising: look-up table means for receiving a bit stream to be communicated, the bit stream being input to the apparatus at a first data rate, and for outputting a digital envelope signal and one or more digital phase signals all at a higher data rate than the first data rate; an envelope digital to analogue converter for converting the digital envelope signal into an analogue envelope signal; and a phase digital to analogue converter for converting the one or more digital phase signals into an analogue phase modulated carrier signal; and a power amplifier having a power input for receiving the analogue envelope signal and a signal input for receiving the analogue phase modulated carrier signal, wherein the analogue phase modulated carrier signal has a substantially constant amplitude.

The term phase signal or signals is used here to represent a signal or signals which contain phase or frequency information but which contain little or no amplitude information (i.e. they have a substantially constant amplitude or envelope).

Preferably, the modulation scheme which the apparatus for performing modulation employs is a highly symmetrical modulation scheme such as for example , QPSK, 8PSK and their offset variants, etc. as opposed to a scheme such as QAM which is much less symmetrical. This enables a relatively modest look-up table means to be employed to produce the digital envelope signal and the one or more digital phase signals.

Preferably, the phase digital to analogue conversion means includes a fractional-N Phase-Locked-Loop which is ideally a multi-accumulator fractional-N Phase-Locked-Loop. Preferably, the envelope digital to analogue conversion means includes a DC/DC converter.

In one possible embodiment of the present invention, there is further provided post-processing means located between the look-up table means and the digital to analogue converters for removing small amplitude, high frequency components from the digital envelope signal and including them into the one or more digital phase signals. In an alternative embodiment, the look-up table means includes post-processing means to ensure that the digital envelope signal output by the look-up table means contains as few high frequency components as possible (by adding these high frequency components to the one or more digital phase signals) such that further post-processing is not required.

In one embodiment of the present invention, the look-up table means outputs only one digital phase signal. In an alternative embodiment, the look-up table means outputs in-phase and quadrature-phase baseband signals having substantially constant combined amplitude.

Preferably, the look-up table means includes adjustable delay means located before the output of the digital envelope signal and the one or more digital phase signals for introducing a relative delay between the digital envelope signal and the one or more digital phase signals.

According to a second aspect of the present invention, there is provided a method of performing modulation, the method comprising the steps of: applying a bit stream to be communicated to look-up table means at a first data rate; outputting from the look-up table means a digital envelope signal and one or more digital phase signals all at a higher data rate than the first data rate; converting the digital envelope signal into an analogue envelope signal; converting the one or more digital phase signals into an analogue phase modulated carrier signal; applying the analogue envelope signal to a power input of a power amplifier; and applying the analogue phase modulated carrier signal to a signal input of the power amplifier, wherein the analogue phase modulated carrier signal has a substantially constant amplitude.

Note that the terms "amplitude" and "envelope" will be used interchangeably throughout this document and have their normal meaning within the field of telecommunications of referring to the maximum value of a periodically varying quantity during a (high frequency) cycle, as extrapolated over the complete cycle to form a continuous cycle (i.e. in the expression of a wave y=A(t).sin(wt + φ), A(t) may be considered either as the amplitude or the envelope of the waveform).

### Brief Description of the Figures

In order that the present invention may be better understood, embodiments thereof will now be described by way of example only with reference to the accompanying drawings in which:-
Figure 1 is a block diagram of a conventional eer modulator;
Figure 2 is a block diagram of an eer modulator according to the present invention;
Figure 3 is a block diagram of another eer modulator according to the present invention;
Figure 4 is a block diagram of yet another eer modulator according to the present invention; and
Figure 5 is a block diagram of yet another eer modulator according to the present invention.

### Detailed description of the Invention

Referring firstly to Figure 2, an eer modulator in accordance with the present invention is illustrated with similar reference numerals being used to describe similar elements to those of Figure 1. The eer modulator of Figure 2 comprises look-up table means 50, envelope post-processing means 61, phase post-processing means 62, envelope Digital to Analogue Converter (DAC) 71, phase DAC 72 and power amplifier 80. Figure 2 additionally shows bit generation means 10 which, as in Figure 1, represents the circuitry associated with the modulator which generates the data to be communicated or transmitted by the modulator (e.g. vocoder or data generation, channel codec, burst formatter, etc.) and aerial 90 from which the output modulated carrier signal is broadcast.

Comparing the modulator of Figure 2 with that of Figure 1, it will be seen that the symbol mapping means 20, signal shaping means 30 and rectangular to polar conversion means 40 of Figure 1 have all been replaced with a single look-up table means 50 in the modulator of Figure 2 (the look-up table means 50 can be considered as comprising an envelope look-up table 51 and a phase look-up table 52). The structure of the modulator of Figure 2 provides a number of advantages over that of Figure 1, firstly because the rectangular to polar conversion means is dispensed with. Note that even though the algorithms for performing this conversion are very simple (A²=I²+Q² ; φ=arctan(Q/I)) actually performing these calculations at the speed required on the large number of bits required to represent the I and Q baseband signals consumes a large number of Millions of Instructions Per Second (MIPS); furthermore, the present inventor has realised that with a symmetrical modulation scheme such as QPSK, 8PSK and their offset variants, etc. it is surprisingly possible to go directly from the input bit stream to separated digital and phase signals using a look-up table 50 without requiring the look-up table to be prohibitively large. Thus the present invention overcomes two popular beliefs within the art of digital signal processing, the first being that where a simple conversion algorithm exists there is little benefit in replacing a real-time calculation mechanism with a look-up table, and the second being that a look-up table for providing separate amplitude and phase signals (as opposed to I and Q signals) would be cumbersomely large for all modulation schemes.

The phase DAC 72 includes a multi-accumulator fractional-N Phase-Locked-Loop (multi-acc frac-N PLL). This is particularly advantageous within the architecture of the present invention because it is only sensitive to frequency and phase information and not to amplitude or envelope information thus reducing the amount of information which needs to be output (and thus stored) within the phase Look-Up Table (LUT) 52. Furthermore, a multi-acc frac-N PLL provides direct conversion from the digital to the analogue domain thus removing the need for a conventional DAC. Of course, it is still possible to superimpose some amplitude or envelope information onto the output of the multi-acc frac-N PLL to be input to the signal input 82 of the power amplifier 80 if not all envelope information is desired to be input to the power amplifier 80 via its power input 81. The amplitude DAC 71 comprises a DC/DC converter which automatically filters out excessively high frequency envelope components which might otherwise adversely affect the operation of the power amplifier 80.

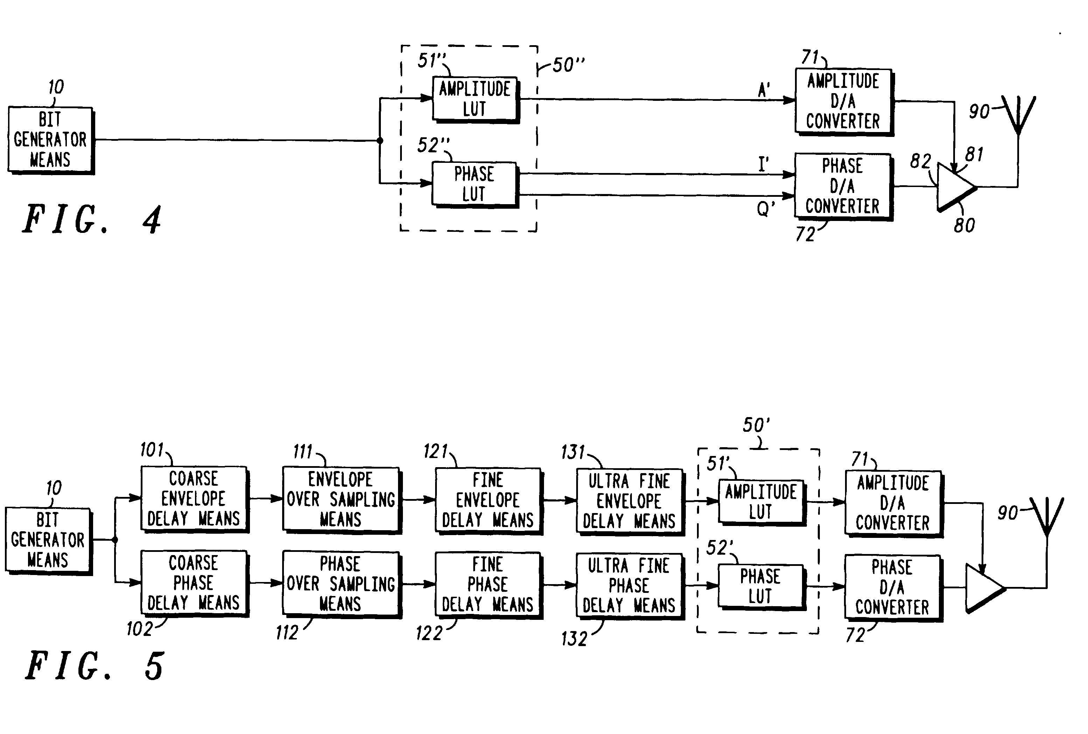

Figure 3 shows another similar modulator to that shown in Figure 2 and similar reference numerals have been used to describe similar elements. Thus it can be seen that the modulator of Figure 3 differs from that of Figure 2 in that the post-processing means 61,62 have been incorporated into look-up tables 51',52' respectively. This arrangement removes yet another MIPS intensive processing step from the modulator thus freeing up a DSP for other functions.

Figure 4 shows another similar modulator to that shown in Figure 3 and similar reference numerals have been used to describe similar elements. Thus it can be seen that the modulator of Figure 4 differs from that of Figure 3 in that the look-up table means 50" generates modified I and Q signals I' and Q' instead of a single phase signal. I' and Q' signals are similar to the I and Q signals which would be generated by conventional symbol mapping and signal shaping means except that amplitude or envelope information has been substantially removed from the modified signals I' and Q' such that they have a substantially constant combined amplitude. Additionally, I' and Q' signals of Figure 1 correspond to post-processed signals in an analogous manner to that performed by look-up table means 50' of Figure 2. However, it will be apparent to a person skilled in the art that post-processing could alternatively be performed by dedicated post-processing means in an analogous manner to that performed in the modulator of Figure 2.

Figure 5 shows another similar modulator to that shown in Figure 3 and similar reference numerals have been used to describe similar elements. However, a further advantage of the present invention is illustrated in Figure 5 by means of coarse, fine and ultrafine envelope 101,121,131 and phase 102,122,132 delay means and envelope 111 and phase 112 oversampling means. The coarse delay means 101,102 are clocked at the first data rate, fₛ, at which the bit stream to be communicated is output from the bit generation means 10. Each coarse delay means can be thought of as comprising a 1 bit wide, variable length shift register which is clocked at the first data rate, fₛ, such that a signal input to it will be delayed by n/fₛ where n may be zero or an integer up to the maximum length of the shift register. The delayed signals output from the coarse delay means 101,102 are input to the oversampling means 111,112 respectively. The oversampling means 111,112 are clocked at a rate Xfₛ where X is an integer such as, for example, 16. The oversampled bit streams are then input to the fine delay means 121,122 which are also clocked at Xfₛ and can be considered as comprising 1 bit wide variable length shift registers whose length, m, can be varied from 0 ≤m ≤ (X-1). In this way the bit streams are further delayed by an amount given by m/Xfₛ. Finally, the delayed bit streams output by the fine delay means 121,122 are input to the ultra fine delay means 131,132. These can either constitute digital delays similar to the fine delay means but clocked at an even greater clocking rate than that of the fine delay means or they can constitute analogue delays which can introduce a variable delay of between 0 and 1/Xfₛ seconds.

Of course, a person skilled in the art would realise that instead of using the data rate fₛ for clocking the coarse delay means, one could use the symbol frequency, to delay symbols (this being effectively equivalent to delaying bits at the data rate). This would then correspond to delaying the data by an integer number of symbols. Of course, where the symbol size was 1 bit the two would be exactly equivalent. Alternatively, the means of using the symbol frequency or a frequency derived from the symbol frequency to delay the data bits or using the data frequency or a frequency derived from the data frequency to delay the symbols could be used.

By varying the amount of delay created by these delay means along one path relative to the other (i.e. either the amplitude or envelope path or the phase path) it is possible to accommodate for different delays introduced by the other elements along these paths thus enabling the synchronisation of the analogue envelope signal with the analogue phase modulated carrier signal as they are input to the power amplifier 80.

Note that such an arrangement would not be possible in the conventional modulator illustrated in Figure 1. Instead, suitable delay means would have to be inserted after the rectangular to polar conversion means and would thus have to be clocked at least at the higher data rate at which the signals are output by the rectangular to polar conversion means 40. Such delay means would need to be as wide as the number of bits used to represent the amplitude and phase signals (e.g. 16 bits) and would need to be sufficiently long to accommodate the maximum possible delay between the different paths. For example, a modulator as shown in Figure 5 having two 1 X 10 coarse delay means and two 1X16 fine delay means would be able to accommodate the same relative delay between the amplitude and phase paths as two 16X160 delay means in the conventional case. Clearly a 16X160 shift register arrangement consumes much more power and occupies much more silicon than a 1X10 and 1X16 shift register arrangements.

Note that the arrangement shown in Figure 5 is intended to be illustrative only and a number of other possible mechanisms will occur to the skilled man which will enable similar reductions in the complexity of the delay mechanisms required to accommodate differences in path length between the phase and amplitude paths which rely on the use of a single look-up table means to convert directly from a bit stream to polar type signals.

## Claims

1. Apparatus for performing modulation, the apparatus comprising: look-up table means for receiving a bit stream to be communicated, the bit stream being input to the apparatus at a first data rate, and for outputting a digital envelope signal and one or more digital phase signals all at a higher data rate than the first data rate; an envelope digital to analogue converter for converting the digital envelope signal into an analogue envelope signal; and a phase digital to analogue converter for converting the one or more digital phase signals into an analogue phase modulated carrier signal; and a power amplifier having a power input for receiving the analogue envelope signal and a signal input for receiving the analogue phase modulated carrier signal, wherein the analogue phase modulated carrier signal has a substantially constant amplitude.

2. Apparatus as claimed in Claim 1 wherein the apparatus for performing modulation employs a highly symmetrical modulation scheme.

3. Apparatus as claimed in either one of the preceding claims further comprising post-processing means located between the look-up table means and the digital to analogue converters for removing small amplitude, high frequency components from the digital envelope signal and including them into the one or more digital phase signals.

4. Apparatus as claimed in either one of Claims 1 or 2 wherein the look-up table means includes post-processing means to ensure that the digital envelope signal output by the look-up table means contains as few high frequency components as possible such that further post-processing is not required.

5. Apparatus as claimed in any one of the preceding claims wherein the look-up table means outputs only one digital phase signal.

6. Apparatus as claimed in any one of Claims 1 to 4 wherein the look-up table means outputs in-phase and quadrature-phase baseband signals having substantially constant combined amplitude.

7. Apparatus as claimed in any one of the preceding claims wherein the look-up table means includes adjustable delay means located before the output of the digital envelope signal and the one or more digital phase signals for introducing a relative delay between the digital envelope signal and the one or more digital phase signals.

8. A method of performing modulation, the method comprising the steps of: applying a bit stream to be communicated to look-up table means at a first data rate; outputting from the look-up table means a digital envelope signal and one or more digital phase signals all at a higher data rate than the first data rate; converting the digital envelope signal into an analogue envelope signal; converting the one or more digital phase signals into an analogue phase modulated carrier signal; applying the analogue envelope signal to a power input of a power amplifier; and applying the analogue phase modulated carrier signal to a signal input of the power amplifier, wherein the analogue phase modulated carrier signal has a substantially constant amplitude.

9. A method of performing modulation as claimed in claim 8 further comprising the steps of: dividing into two the bit stream to be communicated to the look-up table means, wherein one of the divided streams is relied upon by the look-up table means for generating the digital envelope signal and the other divided bit stream is relied upon by the look-up table means for generating the one or more digital phase signals, and adjustably delaying one or both of the divided bit streams for introducing a relative delay between the digital envelope signal and the one or more digital phase signals output by the look up table means.
